# EUROPEAN PATENT APPLICATION

(11) **EP 4 642 176 A1**
(43) Date of publication of application: **29.10.2025**
(21) Application number: 23930031.2
(22) Date of filing: 04.12.2023
(51) Int. Cl.: H05K 7/20, B60L 15/20, H01L 23/473

(54) **LIQUID-COOLING HEAT DISSIPATION DEVICE, ELECTRIC MOTOR CONTROL UNIT, POWER ASSEMBLY AND ELECTRIC VEHICLE**

(30) Priority: 31.03.2023 CN 202310376947
(71) Applicant: HUAWEI DIGITAL POWER TECHNOLOGIES CO., LTD., Shenzhen Guangdong 518043 (CN)
(72) Inventor: TANG, Tingting, Shenzhen, Guangdong 518043 (CN); LI, Jiyang, Shenzhen, Guangdong 518043 (CN); LIU, Hongbing, Shenzhen, Guangdong 518043 (CN); ZHANG, Weilong, Shenzhen, Guangdong 518043 (CN)
(74) Representative: Maiwald GmbH
(86) International application number: PCT/CN2023/136182
(87) International publication number: WO 2024/198465

(57) **Abstract**

This application discloses a liquid cooling heat dissipation apparatus, a motor control unit, a powertrain, and an electric vehicle, to improve compactness of a structure of the liquid cooling heat dissipation apparatus, and improve heat dissipation efficiency of the liquid cooling heat dissipation apparatus. The liquid cooling heat dissipation apparatus includes a cover plate, a middle partition plate, a separator wall, and a bottom plate. The cover plate, the middle partition plate, and the bottom plate are sequentially stacked in a first direction. A gap between the cover plate and the middle partition plate forms a first cavity, and a gap between the bottom plate and the middle partition plate forms a second cavity. The separator wall is arranged between the cover plate and the middle partition plate, and the separator wall is configured to separate the first cavity into a liquid inlet channel and a liquid outlet channel. The cover plate includes two openings. One of the openings communicates with the liquid inlet channel, and the other opening communicates with the liquid outlet channel. The middle partition plate includes at least one group of through holes. Each group of through holes includes one liquid inlet through hole and one liquid outlet through hole. Each liquid inlet through hole is configured to communicate the liquid inlet channel with the second cavity. Each liquid outlet through hole is configured to communicate the liquid outlet channel with the second cavity.

## Description

### CROSS-REFERENCE TO RELATED APPLICATIONS

This application claims priority to Chinese Patent Application No. 202310376947.1, filed with the China National Intellectual Property Administration on March 31, 2023 and entitled "LIQUID COOLING HEAT DISSIPATION APPARATUS, MOTOR CONTROL UNIT, POWERTRAIN, AND ELECTRIC VEHICLE", which is incorporated herein by reference in its entirety.

### TECHNICAL FIELD

This application relates to the field of electric vehicle technologies, and in particular, to a liquid cooling heat dissipation apparatus, a motor control unit, a powertrain, and an electric vehicle.

### BACKGROUND

A powertrain of an electric vehicle needs to drive a motor through a motor control unit (motor control unit, MCU). In a process in which the motor control unit converts a direct current output by a power battery into an alternating current, a plurality of power switching transistors of the motor control unit need to be frequently turned on and off, causing the power switching transistors to generate heat. The motor control unit usually uses a liquid cooling heat dissipation apparatus to dissipate heat for the power switching transistors.

As a power of the motor and a voltage of the power battery in the electric vehicle increase, heat generation of the power switching transistors is increasingly severe. If the heat cannot be dissipated in time, the power switching transistors may be damaged due to an excessively high temperature. In this case, the motor control unit may need to reduce an output power, to reduce the temperature of the power switching transistors. This affects performance of the powertrain and the electric vehicle.

Heat dissipation efficiency of an existing liquid cooling heat dissipation apparatus is low, making it difficult to keep pace with a development trend of high power density in motor control units and powertrains. In addition, a motor and a motor control unit need to be integrated into an all-in-one powertrain. The existing liquid cooling heat dissipation apparatus is large in size and has low heat dissipation efficiency, making it difficult to meet a requirement for miniaturization of the motor control unit and the heat dissipation apparatus.

### SUMMARY

This application provides a liquid cooling heat dissipation apparatus, a motor control unit, a powertrain, and an electric vehicle, to improve compactness of a structure of the liquid cooling heat dissipation apparatus, and improve heat dissipation efficiency of the liquid cooling heat dissipation apparatus.

According to a first aspect, this application provides a liquid cooling heat dissipation apparatus. The liquid cooling heat dissipation apparatus includes a cover plate, a middle partition plate, a separator wall, and a bottom plate. The cover plate, the middle partition plate, and the bottom plate are sequentially stacked in a first direction. In addition, a gap between the cover plate and the middle partition plate forms a first cavity, and a gap between the bottom plate and the middle partition plate forms a second cavity. The separator wall is arranged between the cover plate and the middle partition plate, and the separator wall is configured to separate the first cavity into a liquid inlet channel and a liquid outlet channel. The cover plate includes two openings. The two openings separately extend through the cover plate in the first direction. One of the openings communicates with the liquid inlet channel, and the other opening communicates with the liquid outlet channel. The middle partition plate includes at least one group of through holes. Each group of through holes includes one liquid inlet through hole and one liquid outlet through hole. Each liquid inlet through hole and each liquid outlet through hole separately extend through the middle partition plate in the first direction. In addition, each liquid inlet through hole is configured to communicate the liquid inlet channel with the second cavity, and each liquid outlet through hole is configured to communicate the liquid outlet channel with the second cavity.

In this application, the liquid cooling heat dissipation apparatus implements heat exchange circulation of a heat exchange medium in the liquid cooling heat dissipation apparatus through an upper cavity and a lower cavity. A flow path of the heat exchange medium is simple, and heat dissipation efficiency is high. In addition, the first cavity is jointly formed by the middle partition plate and the cover plate, and the lower cavity is jointly formed by the middle partition plate and the bottom plate. Therefore, this design can effectively reduce a dimension of the liquid cooling heat dissipation apparatus in a height direction, thereby improving compactness of a structure of the liquid cooling heat dissipation apparatus. In addition, a first opening and a second opening are designed on a same side of the liquid cooling heat dissipation apparatus, to facilitate connecting the liquid cooling heat dissipation apparatus to an external pipeline, to reduce difficulty of mounting the liquid cooling heat dissipation apparatus in a power device.

In some implementation solutions, a distance between the two openings is less than the length of the first cavity and is greater than the width of the first cavity. In the first direction, a projection of the liquid inlet channel covers a projection the one opening, and a projection of the liquid outlet channel covers a projection of the other opening. The projections of the two openings do not overlap with the separator wall in the first direction. In this way, the first opening and the second opening may be respectively located on two sides of the cover plate in a length direction. This helps increase regions that the heat exchange medium flows through and that are in the liquid inlet channel and the liquid outlet channel, so that the heat exchange medium can flow more fully through each position in the liquid cooling heat dissipation apparatus, to improve heat dissipation performance of the liquid cooling heat dissipation apparatus.

In some implementation solutions, the middle partition plate includes a first side surface and a second side surface. The first side surface and the second side surface are opposite to each other in the first direction. The first side surface of the middle partition plate includes a first groove. The cover plate and the first groove enclose the first cavity. On one hand, this design facilitates processing of the liquid cooling heat dissipation apparatus. On the other hand, this design can reduce difficulty of assembling the middle partition plate and the cover plate, improve sealing performance of the first cavity, and reduce a risk of liquid leakage of the first cavity.

For example, the cover plate is fastened to the middle partition plate through welding, bonding, or the like, to further improve the sealing performance of the first cavity.

In some implementation solutions, the first groove includes a groove bottom and a groove wall. The separator wall is separately fastened to the groove bottom and the groove wall. The height of the separator wall is less than or equal to the depth of the first groove in the first direction, to facilitate assembling the cover plate and the middle partition plate. A length direction of the separator wall is tilted relative to a length direction of the first groove. The length of the first groove is less than the length of the separator wall. The projection of the liquid inlet channel does not overlap with the projection of the liquid outlet channel in the first direction. In this design, the liquid inlet channel and the liquid outlet channel are separately of a structure in which the width gradually changes. In a direction from the first opening to the second opening, the width of the liquid inlet channel gradually decreases, and the width of the liquid outlet channel gradually decreases. This helps keep balance of a flow rate at each cross section that is in the liquid inlet channel and the liquid outlet channel and that is perpendicular to a length direction of the first cavity, to improve heat dissipation uniformity of a power device.

In some implementation solutions, the second side surface of the middle partition plate includes a second groove. The bottom plate and the second groove enclose the second cavity. On one hand, this can help improve processability of the liquid cooling heat dissipation apparatus. On the other hand, this can reduce difficulty of assembling the middle partition plate and the bottom plate, and improve sealing performance of the second cavity.

In some implementation solutions, the second groove includes a plurality of sub-grooves. The plurality of sub-grooves are sequentially arranged adjacent to each other in a length direction of the middle partition plate. A projection of each sub-groove overlaps with a part of the projection of the liquid inlet channel and a part of the projection of the liquid outlet channel in the first direction. In this way, this design provides feasibility for communication between each sub-groove, and the liquid inlet channel and the liquid outlet channel.

In some implementation solutions, the liquid cooling heat dissipation apparatus includes at least one group of fins. Each group of heat dissipation fins is arranged between the bottom plate and a groove bottom of the second groove, and each group of heat dissipation fins includes a plurality of heat dissipation fins. The length of the heat dissipation fin is less than or equal to the depth of the second groove in the first direction, to reduce difficulty of assembling the bottom plate, the heat dissipation fins, and the middle partition plate. In addition, the projection of each sub-groove covers projections of a plurality of heat dissipation fins in a group of heat dissipation fins in the first direction. After the bottom plate and the middle partition plate are assembled, each group of fins are located in a corresponding sub-groove, and a heat dissipation region may be formed by regions in which the bottom plate corresponds to each sub-groove.

In some implementation solutions, the middle partition plate includes a plurality of groups of through holes. The projection of each sub-groove covers a liquid inlet through hole and a liquid outlet through hole in a group of through holes in the first direction. Each sub-groove can be communicated with the liquid inlet channel through a liquid inlet through hole in a corresponding group of through holes, and be communicated with the liquid outlet channel through a liquid outlet through hole in a corresponding group of through holes. A liquid inlet through hole and a liquid outlet through hole in each group of through holes may be provided opposite to each other at a portion that is of the groove bottom of the first groove and that is away from the separator wall, to facilitate increasing the regions that the heat exchange medium flows through and that are in the liquid inlet channel and the liquid outlet channel, thereby helping improve heat uniformity of the liquid cooling heat dissipation apparatus.

In some implementation solutions, the bottom plate includes a plurality of bottom sub-plates. Each bottom sub-plate encloses with one sub-groove. The bottom sub-plate includes two side surfaces that are opposite to each other in the first direction. A side surface that is of the bottom sub-plate and that faces the sub-groove includes a group of heat dissipation fins. A side surface that is of the bottom sub-plate and that is away from the sub-groove may be used to fasten one power transistor module. In this way, each bottom sub-plate may dissipate heat for the fastened power transistor module. An outer surface area of the bottom sub-plate can be effectively increased by using the heat dissipation fins, thereby improving heat exchange efficiency between the bottom sub-plate and a heat exchange medium in the sub-groove.

In some implementation solutions, the first side surface of the middle partition plate includes two groups of guide racks. The two groups of guide racks are respectively arranged on two sides of the separator wall. In this case, one group of guide racks is located in the liquid inlet channel, and the other group of guide racks is located in the liquid outlet channel. The group of guide racks in the liquid inlet channel is configured to quickly guide a heat exchange medium that enters the liquid inlet channel through the first opening to each liquid inlet through hole. The group of guide racks in the liquid outlet channel is configured to quickly guide, to the second opening, a heat exchange medium that enters the liquid outlet channel from each liquid outlet through hole. This increases a circulation rate of the heat exchange medium in the liquid cooling heat dissipation apparatus, and helps further improve heat dissipation effect on the power transistor module. In addition, in the first direction, the height of each guide rack is less than or equal to a spacing between the middle partition plate and the cover plate, to facilitate assembling the middle partition plate and the cover plate.

In a specific implementation, each group of guide racks includes a plurality of guide racks spaced from each other. A plurality of guide racks in the two groups of guide racks are all tilted relative to the length direction of the middle partition plate, to cooperate with the separator wall to implement a more effective guide function.

In some implementation solutions, the projection of the opening in the first direction is in a shape of a circle, and a plurality of guide racks in a same group of guide racks are tilted at a same angle relative to the length direction of the middle partition plate. The plurality of guide racks in the liquid inlet channel can quickly guide the heat exchange medium to each liquid inlet through hole, and can also balance a flow rate of the heat exchange medium flowing to each liquid inlet through hole. The plurality of guide racks in the liquid outlet channel can quickly guide the heat exchange medium at each liquid outlet through hole to the second opening.

In some other implementation solutions, the projection of the opening in the first direction is in a shape of a track oval. In addition, the width of the opening in the length direction of the middle partition plate is less than the length of the opening in a width direction of the middle partition plate. In a same group of guide racks, an angle at which a plurality of guide racks close to the opening are tilted relative to the length direction of the middle partition plate is greater than an angle at which a plurality of guide racks away from the opening are tilted relative to the length direction of the middle partition plate. Flow resistance of the runaway-shaped opening is small. In the liquid inlet channel, flow resistance of the heat exchange medium flowing to a liquid inlet through hole that is provided close to the opening may be increased by increasing the angle at which the plurality of guide racks close to the opening are tilted relative to the length direction of the middle partition plate. In a region that is away from the opening, flow resistance of the heat exchanger medium flowing to a liquid inlet through hole that is provided away from the opening is reduced by reducing the angle at which the guide racks are tilted relative to the length direction of the middle partition plate. In this way, a flow rate at each liquid inlet through hole can be further balanced.

In some implementation solutions, the middle partition plate includes a plurality of bolt holes. The plurality of bolt holes separately extend through the middle partition plate in the first direction. The cover plate includes a plurality of avoidance grooves, and each avoidance groove is configured to avoid a bolt hole. The liquid cooling heat dissipation apparatus is fastened, through the plurality of bolt holes, to a device for which heat needs to be dissipated. For example, in a length direction of the middle partition plate, each bolt hole is arranged between two adjacent liquid inlet through holes, or each bolt hole is arranged between two adjacent liquid outlet through holes. In this way, the bolt holes can be dispersedly distributed on the middle partition plate, so that force uniformity of the liquid cooling heat dissipation apparatus can be improved, and the width of the middle partition plate can be reduced, thereby reducing the overall width of the liquid cooling heat dissipation apparatus, and helping implement miniaturization of the liquid cooling heat dissipation apparatus.

According to a second aspect, this application further provides a motor control unit. The motor control unit includes a power module and the liquid cooling heat dissipation apparatus according to any implementation solution of the first aspect. The power module includes one or more power transistor modules. Each power transistor module is fastened to a side surface that is of the backplane and that is away from the second cavity, and each power transistor module includes one or more power transistors. After the heat generated by the power transistor module during working is transferred to the bottom plate, the heat may be further transferred by the bottom plate to a heat exchange medium. Finally, the heat exchange medium takes heat out from a power device in a circulation process, thereby implementing heat dissipation and temperature reduction of the power transistor module. Because heat dissipation efficiency of the liquid cooling heat dissipation apparatus is high, good heat dissipation effect can be implemented for the motor control unit, so that working reliability of the motor control unit is improved. In addition, a compact structure of the liquid cooling heat dissipation apparatus also provides a condition for a miniaturization design of a dimension of the motor control unit.

According to a third aspect, this application further provides a powertrain. The powertrain includes a motor and the motor control unit according to the second aspect. The motor control unit is configured to drive the motor. Specifically, the motor control unit receives a direct current output by a battery and outputs an alternating current to drive the motor. The motor receives power supplied by the motor control unit and drives wheels. Under the condition that the miniaturization design is implemented for the motor control unit, a structure dimension of the powertrain is also reduced.

According to a fourth aspect, this application further provides an electric vehicle. The electric vehicle includes a battery, wheels, and the powertrain according to the third aspect. The powertrain is configured to receive power supplied by the battery and drive the wheels, to drive the vehicle to travel.

### BRIEF DESCRIPTION OF DRAWINGS

FIG. 1 is a diagram of an electric vehicle according to an embodiment of this application;
FIG. 2 is a diagram of a liquid cooling heat dissipation apparatus according to an embodiment of this application;
FIG. 3 is another diagram of the liquid cooling heat dissipation apparatus shown in FIG. 2;
FIG. 4 is a diagram of a first side surface of a middle partition plate according to an embodiment of this application;
FIG. 5 is a diagram of a second side surface of a middle partition plate according to an embodiment of this application;
FIG. 6 is another diagram of a partial structure of a liquid cooling heat dissipation apparatus according to an embodiment of this application;
FIG. 7 is another diagram of a partial structure of a middle partition plate according to an embodiment of this application;
FIG. 8 is another diagram of a liquid cooling heat dissipation apparatus according to an embodiment of this application;
FIG. 9 is another diagram of a liquid cooling heat dissipation apparatus according to an embodiment of this application; and
FIG. 10 is another diagram of a motor control unit according to an embodiment of this application.

Reference numerals:
100: battery; 200: powertrain; 300: wheels; 400: motor control unit; 410: liquid cooling heat dissipation apparatus; 411: middle partition plate;
411a: first side surface of a middle partition plate; 411b: second side surface of a middle partition plate; 4111: first groove; 41111: groove bottom;
41112: groove wall; 4112: second groove; 41121: sub-groove; 4113, 4113a, 4113b, and 4113c: liquid inlet through holes;
4114: liquid outlet through hole; 4115: guide rack; 4116: bolt hole; 412: cover plate; 4121: first opening;
4122: second opening; 4123: avoidance groove; 413: bottom plate; 4131: bottom sub-plate; 4132: fin; 4133: heat dissipation region;
414: first cavity; 4141: liquid inlet channel; 4142: liquid outlet channel; 415: second cavity; 416: separator wall;
417: first pipeline connector; 418: second pipeline connector; 420: power device; 420: power transistor module; 421: power transistor;
422: bearing substrate; and 500: motor.

### DESCRIPTION OF EMBODIMENTS

To make the objectives, technical solutions, and advantages of this application clearer, the following further describes the embodiments of this application in detail with reference to the accompanying drawings. However, example implementations may be implemented in a plurality of forms, and should not be construed as being limited to implementations described herein. Identical reference numerals in the accompanying drawings denote identical or similar structures. Therefore, repeated description thereof is omitted.

Expressions of positions and directions in embodiments of this application are described by using the accompanying drawings as an example. However, changes may also be made as required, and all the changes fall within the protection scope of this application. The accompanying drawings in embodiments of this application are merely used to illustrate a relative position relationship and do not represent an actual scale.

It should be noted that specific details are set forth in the following descriptions for ease of understanding this application. However, embodiments of this application can be implemented in a plurality of manners different from those described herein, and a person skilled in the art can perform similar generalization without departing from the connotation of embodiments of this application. Therefore, this application is not limited to the specific implementations disclosed below.

A power transistor module is a main heat generating component in a power device. If heat cannot be dissipated in time, the power transistor module is easily damaged due to over-temperature. Therefore, the power transistor module is usually configured with an independent liquid cooling heat dissipation apparatus to dissipate heat, to improve working reliability of the power transistor module. Currently, the liquid cooling heat dissipation apparatus of the power transistor module usually uses a water cooling manner to dissipate heat. A plurality of channels are disposed in the liquid cooling heat dissipation apparatus, so that cooling water takes away heat generated by the power transistor module when the cooling water circulates in the liquid cooling heat dissipation apparatus. However, the existing liquid cooling heat dissipation apparatus that uses the water cooling manner is usually excessively large in size and has low heat dissipation efficiency, which makes it difficult to match a development trend of miniaturization and high efficiency of a power device.

In view of this, embodiments of this application provide a liquid cooling heat dissipation apparatus, a motor control unit, a powertrain, and an electric vehicle. On a premise that efficient heat dissipation is implemented, compactness of a structure of the liquid cooling heat dissipation apparatus can be improved. In this way, an advantageous condition for a miniaturization design of the motor control unit and the powertrain is provided, and performance of the motor control unit, the powertrain, and the electric vehicle is improved. With reference to the accompanying drawings, the following specifically describes a liquid cooling heat dissipation apparatus, a motor control unit, a powertrain, and an electric vehicle that are provided in embodiments of this application.

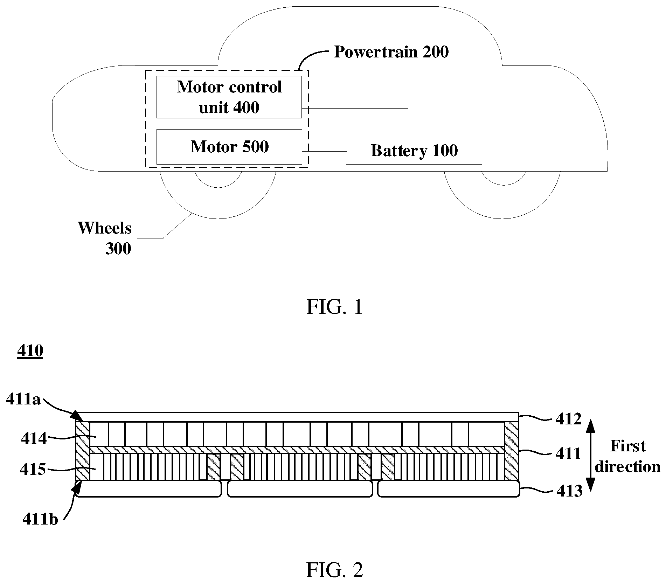

FIG. 1 is a diagram of an electric vehicle according to an embodiment of this application. With reference to FIG. 1, the electric vehicle provided in this embodiment of this application includes a battery 100, a powertrain 200, and wheels 300. The powertrain 200 is configured to receive power supplied by the battery 100 and drive the wheels 300. In this embodiment of this application, the electric vehicle includes an electric vehicle or a hybrid vehicle, and the battery 100 includes a large-capacity and high-power power battery.

With reference to FIG. 1, the powertrain 200 provided in this embodiment of this application includes a motor control unit 400 and a motor 500. The motor control unit 400 is configured to drive the motor 500. Specifically, the motor control unit 400 receives a direct current output by the battery 100 and outputs an alternating current to drive the motor 500. The motor 500 receives power supplied by the motor control unit 400 and drives the wheels 300.

The motor control unit 400 provided in this embodiment of this application includes a power module and a liquid cooling heat dissipation apparatus. In this embodiment of this application, the power module includes one or more power transistor modules, and each power transistor module includes one or more power transistors. The plurality of power transistors in a power module form a bridge arm circuit of a direct current-to-alternating current conversion circuit.

In an embodiment, the power module includes three power transistor modules, and each power transistor module includes two power transistors. The two power transistors in each power transistor module form a bridge arm circuit, and the three power transistor modules form a three-phase inverter circuit. The three-phase inverter circuit is configured to convert a direct current output by the battery 100 into a three-phase alternating current.

The liquid cooling heat dissipation apparatus provided in this embodiment of this application includes a cover plate, a middle partition plate, a separator wall, and a bottom plate. The cover plate, the middle partition plate, and the bottom plate are sequentially stacked in a first direction. In addition, a gap between the cover plate and the middle partition plate forms a first cavity, and a gap between the bottom plate and the middle partition plate forms a second cavity. The separator wall is arranged between the cover plate and the middle partition plate, and the separator wall is configured to separate the first cavity into a liquid inlet channel and a liquid outlet channel. The cover plate includes two openings. The two openings separately extend through the cover plate in the first direction. One of the openings communicates with the liquid inlet channel, and the other opening communicates with the liquid outlet channel. The middle partition plate includes at least one group of through holes. Each group of through holes includes one liquid inlet through hole and one liquid outlet through hole. Each liquid inlet through hole and each liquid outlet through hole separately extend through the middle partition plate in the first direction. In addition, each liquid inlet through hole is configured to communicate the liquid inlet channel with the second cavity, and each liquid outlet through hole is configured to communicate the liquid outlet channel with the second cavity.

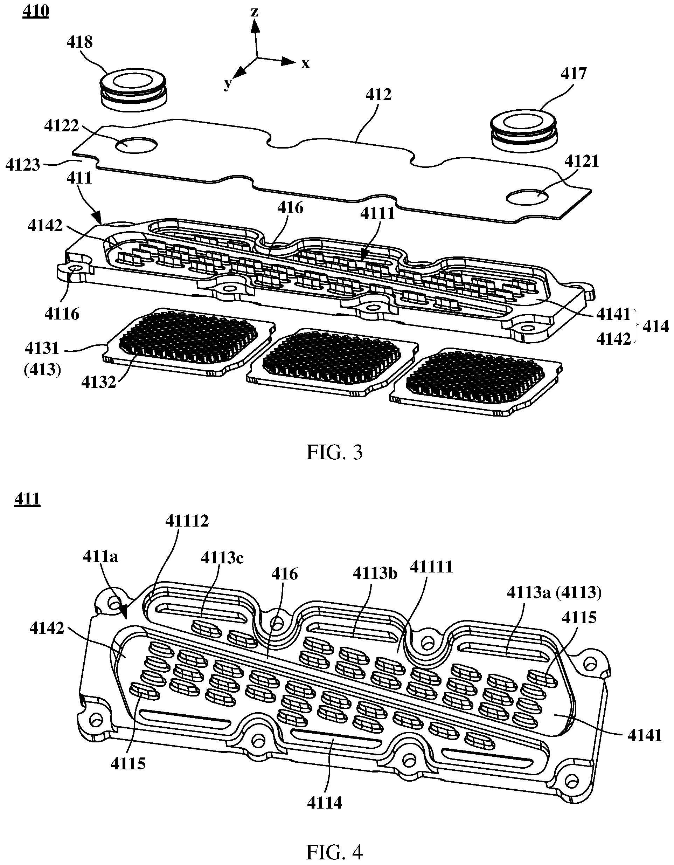

FIG. 2 is a diagram of a liquid cooling heat dissipation apparatus according to an embodiment of this application. FIG. 3 is another diagram of the liquid cooling heat dissipation apparatus shown in FIG. 2.

With reference to both FIG. 2 and FIG. 3, the liquid cooling heat dissipation apparatus 410 includes a cover plate 412, a middle partition plate 411, and a bottom plate 413. The cover plate 412, the middle partition plate 411, and the bottom plate 413 are sequentially stacked in a first direction. There are gaps between the cover plate 412 and the middle partition plate 411, and between the bottom plate 413 and the middle partition plate 411, respectively. The gap between the cover plate 412 and the middle partition plate 411 forms a first cavity 414, and the gap between the bottom plate 413 and the middle partition plate 411 forms a second cavity 415. A side surface that is of the bottom plate 413 and that is away from the second cavity 415 may be used to fasten a device for which heat needs to be dissipated. Coolant flows through the first cavity 414 and the second cavity 415 of the liquid cooling heat dissipation apparatus 410, to dissipate heat for the device for which heat needs to be dissipated. For example, the device for which heat needs to be dissipated is a power transistor module of a motor control unit.

In this embodiment of this application, the device for which heat needs to be dissipated includes a power transistor module of a motor control unit, or a power transistor module of a converter in an energy storage system, or a power transistor module of an optimizer or an inverter in a photovoltaic system, or a device that generates heat such as a capacitor, an inductor, a resistor, or a transformer in a power device. Correspondingly, the liquid cooling heat dissipation apparatus 410 provided in this embodiment of this application may be used in a powertrain or a motor control unit of an electric vehicle, or may be used in a converter in an energy storage system, an optimizer or an inverter in a photovoltaic system, or another power device. For ease of description, in this embodiment of this application, an example in which the device for which heat needs to be dissipated is a power transistor module is used for description.

In this embodiment of this application, the first direction may be understood as a direction at which the cover plate 412, the middle partition plate 411, and the bottom plate 413 are stacked. Alternatively, the first direction may be understood as a thickness direction of the cover plate 412, the middle partition plate 411, or the bottom plate 413.

In an embodiment, the middle partition plate 411 may be substantially of a cuboid structure. For example, an area of a cross section that is of the middle partition plate 411 and that is perpendicular to the first direction is equal to 20 times an area of a cross section that is of the middle partition plate 411 and that is perpendicular to a length direction of the middle partition plate 411. This helps increase a relative area between the middle partition plate 411 and the bottom plate 413, thereby increasing a heat dissipation area of the liquid cooling heat dissipation apparatus 410.

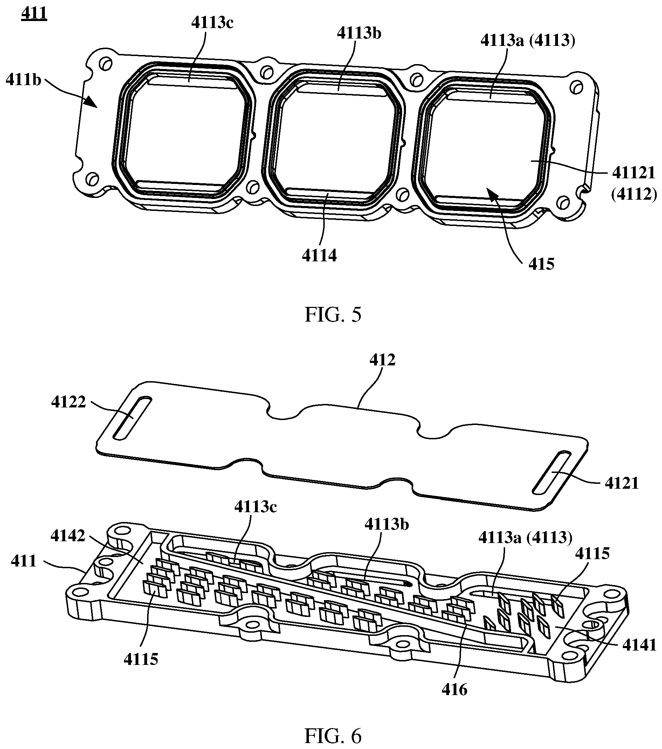

FIG. 4 is a diagram of a first side surface of the middle partition plate 411 according to an embodiment of this application. FIG. 5 is a diagram of a second side surface of the middle partition plate 411 according to an embodiment of this application. With reference to FIG. 3 to FIG. 5, the middle partition plate 411 includes a first side surface 411a and a second side surface 411b. The first side surface 411a and the second side surface 411b are opposite to each other in the first direction. The first side surface 411a of the middle partition plate 411 includes a first groove 4111. The cover plate 412 and the first groove 4111 enclose the first cavity 414.

In this embodiment of this application, the cover plate 412 and the first groove 4111 enclose the first cavity 414. On one hand, this facilitates processing of the liquid cooling heat dissipation apparatus 410. On the other hand, this can reduce difficulty of assembling the middle partition plate 411 and the cover plate 412, improve sealing performance of the first cavity 414, and reduce a risk of liquid leakage of the first cavity 414.

In an embodiment, the second side surface 411b of the middle partition plate 411 includes a second groove 4112. The bottom plate 413 and the second groove 4112 enclose the second cavity 415.

In this embodiment of this application, the bottom plate 413 and the second groove 4112 enclose the second cavity 415. This can improve processability of the liquid cooling heat dissipation apparatus. In addition, this can reduce difficulty of assembling the middle partition plate 411 and the bottom plate 413, improve sealing performance of the second cavity 415, and further reduce a risk of liquid leakage of the second cavity 415.

In some implementation solutions, the cover plate 412, the bottom plate 413, or the middle partition plate 411 includes one or more of metal materials such as copper and aluminum, or non-metal materials such as plastic. In an embodiment, the cover plate 412, the bottom plate 413, and the middle partition plate 411 include metal materials, and the cover plate 412 or the bottom plate 413 is fastened to the middle partition plate 411 through welding or bonding. Alternatively, in an embodiment, the cover plate 412, the bottom plate 413, and the middle partition plate 411 include non-metal materials, and the cover plate 412 or the bottom plate 413 is fastened to the middle partition plate 411 through bonding.

In some implementations, a sealing ring may be disposed between the cover plate 412 or the bottom plate 413 and the middle partition plate 411, to improve sealing performance between the bottom plate 413 and the middle partition plate 411 or between the cover plate 412 and the middle partition plate 411, thereby reducing a risk of leakage of an internal heat exchange medium or coolant. In this embodiment of this application, the sealing ring may use one or more of high-temperature-resistant and corrosion-resistant rubber, graphite, or asbestos medium materials.

Still with reference to FIG. 3 to FIG. 5, the liquid cooling heat dissipation apparatus 410 includes a separator wall 416. The separator wall 416 is arranged between the cover plate 412 and the middle partition plate 411. The separator wall 416 separates the first cavity 414 into a liquid inlet channel 4141 and a liquid outlet channel 4142.

Still with reference to FIG. 3 to FIG. 5, the cover plate 412 includes two openings. The two openings separately extend through the cover plate in the first direction. One of the openings communicates with the liquid inlet channel 4141, and the other opening communicates with the liquid outlet channel 4142.

For ease of description, in this embodiment of this application, the opening that communicates with the liquid inlet channel 4141 is referred to as a first opening 4121, and the opening that communicates with the liquid outlet channel 4142 is referred to as a second opening 4122.

The first opening 4121 and the second opening 4122 may be separately connected to an external cooling device through pipelines. In this embodiment of this application, the external cooling device includes a cooling device such as a heat exchanger, a cooler, or an air conditioner. A heat exchange medium or coolant repeatedly circulates between the cooling device and the liquid cooling heat dissipation apparatus 410, thereby implementing heat dissipation. In this embodiment of this application, the heat exchange medium includes one of cooling oil, cooling water, or coolant.

In some implementations, a distance between the first opening 4121 and the second opening 4122 is less than the length of the first cavity 414 and is greater than the width of the first cavity 414. In the first direction, a projection of the liquid inlet channel 4141 covers a projection of the first opening 4121, and a projection of the liquid outlet channel 4142 covers a projection of the second opening 4122. The projection of the first opening 4121 and the projection of the second opening 4122 do not overlap with the separator wall 416 in the first direction. Correspondingly, the first opening 4121 and the second opening 4122 may be respectively located on two sides of the cover plate 412 in a length direction. This helps increase regions that the heat exchange medium flows through and that are in the liquid inlet channel 4141 and the liquid outlet channel 4142, so that the heat exchange medium can flow more fully through each position in the liquid cooling heat dissipation apparatus 410, thereby improving heat dissipation performance of the liquid cooling heat dissipation apparatus 410.

In addition, to reduce difficulty of connecting the first opening 4121 and the second opening 4122 to the pipelines, the liquid cooling heat dissipation apparatus 410 further includes a first pipeline connector 417 and a second pipeline connector 418. The first pipeline connector 417 and the second pipeline connector 418 are respectively fastened on a side surface that is of the cover plate and that is away from the first cavity. The first pipeline connector 417 is configured to connect the first opening 4121 to a corresponding pipeline, and the second pipeline connector 418 is configured to connect the second opening 4122 to a corresponding pipeline.

Still with reference to FIG. 3 to FIG. 5, the middle partition plate 411 includes at least one group of through holes. Each group of through holes includes one liquid inlet through hole 4113 and one liquid outlet through hole 4114. Each liquid inlet through hole 4113 and each liquid outlet through hole 4114 separately extend through the middle partition plate 411 in the first direction. In addition, each liquid inlet through hole 4113 is configured to communicate the liquid inlet channel 4141 with the first cavity 414, and each liquid outlet through hole 4114 is configured to communicate the liquid outlet channel 4142 with the second cavity 415.

In this embodiment of this application, a device for which heat needs to be dissipated exchanges heat with the bottom plate 413. The heat exchange medium flows to the liquid inlet channel 4141 through the first opening 4121, and the liquid inlet channel 4141 transfers the heat exchange medium to the second cavity 415 through the liquid inlet through hole 4113. The heat exchange medium in the second cavity 415 exchanges heat with the bottom plate 413 and then enters the liquid outlet channel 4142 through the liquid outlet through hole 4114, and the liquid outlet channel 4142 outputs a heat exchange medium through the second opening 4122.

In this embodiment of this application, the liquid cooling heat dissipation apparatus 410 implements heat exchange circulation of the heat exchange medium in the liquid cooling heat dissipation apparatus 410 through an upper cavity and a lower cavity. A flow path of the heat exchange medium is simple, and heat exchange efficiency is high. In addition, the first cavity 414 is jointly formed by the middle partition plate 411 and the cover plate 412, and the second cavity 415 is jointly formed by the middle partition plate 411 and the bottom plate 413. Therefore, this design can effectively reduce a dimension of the liquid cooling heat dissipation apparatus 410 in a height direction, thereby improving compactness of a structure of the liquid cooling heat dissipation apparatus 410. In addition, the first opening 4121 and the second opening 4122 are designed on a same side of the liquid cooling heat dissipation apparatus 410, to facilitate connecting the liquid cooling heat dissipation apparatus 410 to an external pipeline, thereby reducing difficulty of mounting the liquid cooling heat dissipation apparatus 410 in a power device.

Still with reference to FIG. 3 to FIG. 5, in this embodiment of this application, the first groove 4111 includes a groove bottom 41111 and a groove wall 41112. The separator wall 416 is separately fastened to the groove bottom 41111 and the groove wall 41112. The height of the separator wall 416 is less than or equal to the depth of the first groove 4111 in the first direction. A length direction of the separator wall 416 is tilted relative to a length direction of the first groove 4111. The length of the first groove 4111 is less than the length of the separator wall 416. The projection of the liquid inlet channel 4141 does not overlap with the projection of the liquid outlet channel 4142 in the first direction.

In this embodiment of this application, the separator wall 416 and the middle partition plate 411 are of integrated structures. In this way, an assembly process can be simplified, and the liquid inlet channel 4141 and the liquid outlet channel 4142 can be better isolated. In addition, the height of the separator wall 416 is less than or equal to the depth of the first groove 4111 in the first direction, to facilitate assembling the cover plate 412 and the middle partition plate 411. In addition, even if there is a gap between the top of the separator wall 416 and the cover plate 412 after assembly, the gap may be filled with an adhesive, to ensure isolation between the liquid inlet channel 4141 and the liquid outlet channel 4142. As shown in FIG. 4, in a direction from the first opening 4121 to the second opening 4122, the width of the liquid inlet channel 4141 gradually decreases, and in a direction from the second opening 4122 to the first opening 4121, the width of the liquid outlet channel 4142 gradually decreases.

In this embodiment of this application, the liquid inlet channel 4141 is designed as a structure in which the width gradually changes. After the heat exchange medium flows to the liquid inlet channel 4141 through the first opening 4121, a flow rate of the heat exchange medium becomes higher as the width of the liquid inlet channel 4142 becomes narrower. This helps keep balance of a flow rate at each cross section that is in the liquid inlet channel 4142 and that is perpendicular to a length direction of the first cavity. Therefore, the heat exchange medium flowing to the second cavity 415 from each liquid inlet through hole 4113 may also be approximately equal, thereby improving heat dissipation uniformity of the power transistor module.

In this embodiment of this application, the second groove 4112 includes a plurality of sub-grooves 41121. The plurality of sub-grooves 41121 are sequentially arranged adjacent to each other in a length direction of the middle partition plate 411. In addition, a projection of each sub-groove 41121 overlaps with a part of the projection of the liquid inlet channel 4141 and a part of the projection of the liquid outlet channel 4142 in the first direction. Still with reference to FIG. 3 to FIG. 5, a projection of each sub-groove 41121 overlaps with a part of the projection of the liquid inlet channel 4141 in the first direction, and a projection of each sub-groove 41121 overlaps with a part of the projection of the liquid outlet channel 4142 in the first direction.

In this embodiment of this application, the middle partition plate 411 includes a plurality of groups of through holes. The projection of the sub-groove 41121 covers 4113 and a liquid outlet through hole 4114 in a group of through holes in the first direction. A 4113 and a liquid outlet through hole 4114 in each group of through holes are provided opposite to each other at a portion that is of the groove bottom of the first groove 4111 and that is away from the separator wall 416.

Still with reference to FIG. 3 to FIG. 5, the projection of each sub-groove 41121 covers the liquid inlet through hole 4113 and the liquid outlet through hole 4114 in a group of through holes in the first direction. Correspondingly, each sub-groove 41121 can be communicated with the liquid inlet channel 4141 through a liquid inlet through hole 4113 in a corresponding group of through holes, and be communicated with the liquid outlet channel 4142 through a liquid outlet through hole 4114 in a corresponding group of through holes. In addition, a liquid inlet through hole 4113 and a liquid outlet through hole 4114 in each group of through holes may be provided opposite to each other at a portion that is of the groove bottom of the first groove 4111 and that is away from the separator wall 416, to facilitate increasing the regions that the heat exchange medium flows through and that are in the liquid inlet channel 4141 and the liquid outlet channel 4142, thereby helping improve heat uniformity of the liquid cooling heat dissipation apparatus 410.

In this embodiment of this application, the bottom plate 413 includes a plurality of bottom sub-plates 4131. Each bottom sub-plate 4131 is configured for enclosing with one sub-groove 41121. The bottom sub-plate 4131 includes two side surfaces that are opposite to each other in the first direction. A side surface that is of the bottom sub-plate 4131 and that faces the sub-groove 41121 includes a group of heat dissipation fins 4132. A side surface that is of the bottom sub-plate 4131 and that is away from the sub-groove 41121 may be used to fasten one power transistor module. Correspondingly, the side surface that is of the bottom sub-plate 4131 and that is away from the sub-groove 41121 is in contact with the power transistor module in a thermally conductive manner.

In this embodiment of this application, the liquid cooling heat dissipation apparatus includes at least one group of fins 4132. Each group of fins 4132 is arranged between the bottom plate 413 and a groove bottom of the second groove 4112. Each group of heat dissipation fins 4132 includes a plurality of heat dissipation fins. The length of the heat dissipation fin is less than or equal to the depth of the second groove 4112 in the first direction, thereby reducing difficulty of assembling the bottom plate 413 and the middle partition plate 411 and difficulty of processing the heat dissipation fins.

In this embodiment of this application, the length of the heat dissipation fins 4132 is less than or equal to the depth of the sub-groove 41121 in the first direction, to reduce difficulty of assembling the bottom sub-plate 4131 and the middle partition plate 411. An outer surface area of the bottom sub-plate 4131 can be effectively increased by using the heat dissipation fins 4132, thereby improving heat exchange efficiency between the bottom sub-plate 4131 and a heat exchange medium. In this embodiment of this application, the heat dissipation fin includes a pin fin.

In this embodiment of this application, the projection of each sub-groove 41121 of the second groove 4112 covers projections of a plurality of heat dissipation fins in a group of heat dissipation fins 4132 in the first direction. After the bottom plate 413 and the middle partition plate 411 are assembled, each group of fins 4132 are located in a corresponding sub-groove 41121, and a heat dissipation region 4133 may be formed by regions in which the bottom plate 413 corresponds to each sub-groove 41121. In this case, the liquid cooling heat dissipation apparatus 410 also implements heat exchange circulation of the heat exchange medium in the liquid cooling heat dissipation apparatus 410 through an upper cavity and a lower cavity. In addition, the first cavity 414 is jointly formed by the middle partition plate 411 and the cover plate 412, and the second cavity 415 is jointly formed by the middle partition plate 411 and the bottom plate 413. Therefore, this design can effectively reduce a dimension of the liquid cooling heat dissipation apparatus 410 in a height direction, thereby improving compactness of a structure of the liquid cooling heat dissipation apparatus 410.

Based on the foregoing design in which the separator wall 416 is tilted relative to a length direction of the first groove 4111, balance of a flow rate at each cross section that is in the liquid inlet channel 4141 and that is perpendicular to a length direction of the first cavity 414 may be kept. In this way, flow directions of the liquid inlet through holes 4113 entering the corresponding sub-grooves 41121 are approximately equal. Therefore, heat dissipation effect that can be implemented by the bottom sub-plates 4131 are also close, thereby further achieving balanced heat dissipation effect for each power transistor module.

In this embodiment of this application, the first side surface 411a of the middle partition plate 411 includes two groups of guide racks 4115. The two groups of guide racks 4115 are respectively arranged on two sides of the separator wall 416. Each group of guide racks 4115 includes a plurality of guide racks 4115 spaced from each other. The height of each guide rack 4115 is less than or equal to a spacing between the middle partition plate 411 and the cover plate 412 in the first direction.

Correspondingly, the middle partition plate 411 is integrated with the two groups of guide racks 4115, which can improve processing and assembly efficiency and facilitate assembling the middle partition plate 411 and the cover plate 412. In addition, the guide racks 4115 in the liquid inlet channel 4141 enable the heat exchange medium to be quickly guided from the first opening 4121 to each liquid inlet through hole 4113 and enter the second cavity 415, thereby improving a circulation rate of the heat exchange medium in the liquid cooling heat dissipation apparatus 410, and helping further improve heat dissipation effect of the power transistor module. Similarly, the guide racks 4115 in the liquid outlet channel 4142 enable the heat exchange medium to be quickly guided from each liquid outlet through hole 4114 to the second opening 4122, and then be discharged to the outside of the liquid cooling heat dissipation apparatus 410 through the second opening 4122.

In an embodiment, a plurality of guide racks 4115 in the two groups of guide racks 4115 are all tilted relative to the length direction of the middle partition plate 411, to cooperate with the separator wall 416 to implement a more effective guide function.

In an embodiment, the projection of the opening, of the cover plate 412, in the first direction is in a shape of a circle, and a plurality of guide racks 4115 in a same group of guide racks 4115 are tilted at a same angle relative to the length direction of the middle partition plate 411.

In an embodiment, projections of the first opening 4121 and the second opening 4122 in the first direction are in a shape of a circle. As shown in FIG. 3, the projection of at least one of the first opening 4121 or the second opening 4122 in the first direction is in a shape of a circle. The plurality of guide racks 4115 in a same group of guide racks 4115 may be separately disposed in parallel with the separator wall 416, to cooperate with the separator wall 416. The plurality of guide racks 4115 in the liquid inlet channel 4141 can quickly guide the heat exchange medium to each liquid inlet through hole 4113, and can also balance a flow rate of the heat exchange medium flowing to each liquid inlet through hole 4113. The plurality of guide racks 4115 in the liquid outlet channel 4142 can quickly guide the heat exchange medium at each liquid outlet through hole 4114 to the second opening 4122.

In an embodiment, the projection of the opening, of the cover plate 412, in the first direction is in a shape of a track oval. The width of the opening of the cover plate 412 in the length direction of the middle partition plate 411 is less than the length of the opening in a width direction of the middle partition plate 411. In an embodiment, the projection of the first opening 4121 in the first direction is in a shape of a track oval. A width of the first opening 4121 in the length direction of the middle partition plate 411 is less than a length of the first opening 4121 in a width direction of the middle partition plate 411. The projection of the second opening 4122 in the first direction is in a shape of a track oval. A width of the second opening 4122 in the length direction of the middle partition plate 411 is less than a length of the second opening 4122 in the width direction of the middle partition plate 411.

FIG. 6 is another diagram of a partial structure of the liquid cooling heat dissipation apparatus 410 according to an embodiment of this application. With reference to FIG. 6, the projection of the first opening 4121 in the first direction is in a shape of a track oval. The width of the first opening 4121 in the length direction of the middle partition plate 411 is less than the length of the first opening 4121 in the width direction of the middle partition plate 411. The projection of the second opening 4122 in the first direction is also in a shape of a track oval. In addition, the width of the second opening 4122 in the length direction of the middle partition plate 411 is less than the length of the second opening 4122 in the width direction of the middle partition plate 411.

In a group of guide racks 4115 in the liquid inlet channel 4141, an angle at which a plurality of guide racks 4115 close to the first opening are tilted relative to the length direction of the middle partition plate 411 is greater than an angle at which a plurality of guide racks 4115 away from the first opening 4121 are tilted relative to the length direction of the middle partition plate 411.

The track oval-shaped first opening 4121 is used, so that flow resistance is small. Therefore, an instantaneous flow rate of the heat exchange medium entering the liquid inlet channel 4141 through the first opening 4121 is large. The angle at which the plurality of guide racks 4115 close to the first opening 4121 are tilted relative to the length direction of the middle partition plate 411 is increased, so that flow resistance of the heat exchange medium flowing to the liquid inlet through hole 4113a provided close to the first opening 4121 can be increased to some extent. In this way, a flow rate at the liquid inlet through hole 4113a can be reduced. In a region away from the first opening 4121, the angle at which the guide racks 4115 are tilted relative to the length direction of the middle partition plate 411 is reduced, which helps reduce flow resistance of the heat exchange medium flowing to the liquid inlet through hole 4113b and the liquid inlet through hole 4113c. In combination with a tilt design of the separator wall 416, this can further balance a flow rate at each liquid inlet through hole 4113.

In this case, a group of guide racks 4115 in the liquid outlet channel 4142 may be disposed with reference to the group of guide racks 4115 in the liquid inlet channel 4141. That is, an angle at which a plurality of guide racks 4115 close to the second opening 4122 are tilted relative to the length direction of the middle partition plate 411 is greater than an angle at which a plurality of guide racks 4115 away from the second opening 4122 are tilted relative to the length direction of the middle partition plate 411.

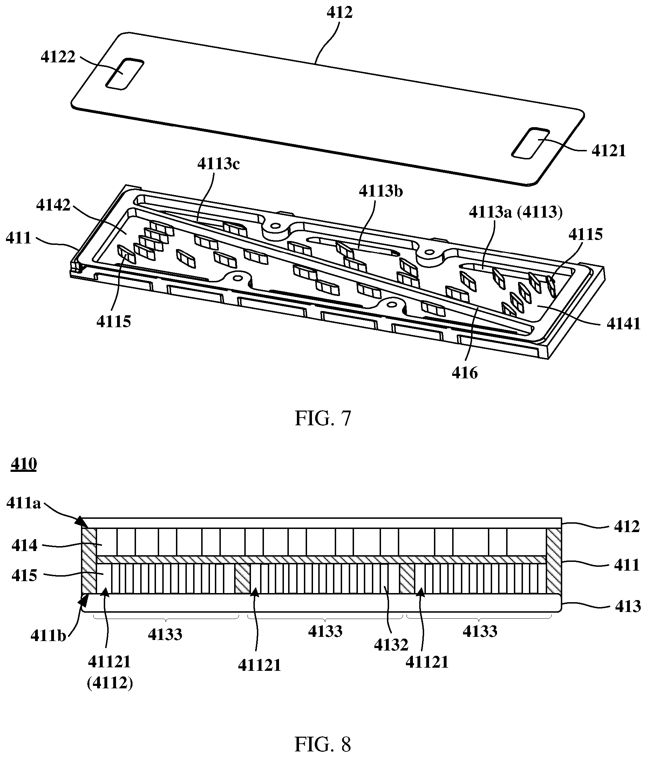

FIG. 7 is another diagram of a partial structure of the middle partition plate 411 according to an embodiment of this application. With reference to FIG. 7, in this application, the projection of the first opening 4121 in the first direction is also in a shape of a track oval. In addition, the width of the first opening 4121 in the length direction of the middle partition plate 411 is less than the length of the first opening 4121 in the width direction of the middle partition plate 411. A length-width ratio of the first opening 4121 may be equal to a length-width ratio of the first opening 4121 in the foregoing embodiment, or is greater than or less than a length-width ratio of the first opening 4121 in the foregoing embodiment.

In this embodiment, in a group of guide racks 4115 in the liquid inlet channel 4141, an angle at which a plurality of guide racks 4115 away from a direction the first opening 4121 are tilted relative to the length direction of the middle partition plate 411 gradually decreases. This design may also increase flow resistance of the heat exchange medium flowing to the liquid inlet through hole 4113a, and reduce flow resistance of the heat exchange medium flowing to the liquid inlet through hole 4113b and the liquid inlet through hole 4113c. In combination with a tilt design of the separator wall 416, this can further balance a flow rate at each liquid inlet through hole 4113.

In an embodiment, the projection of the second opening 4122 in the first direction is also in a shape of a track oval. In addition, the width of the second opening 4122 in the length direction of the middle partition plate is less than the length of the second opening 4122 in the width direction of the middle partition plate. In this case, a group of guide racks 4115 in the liquid outlet channel 4142 may be disposed with reference to the group of guide racks 4115 in the liquid inlet channel 4141. That is, an angle at which a plurality of guide racks 4115 away from a direction of the second opening 4122 are tilted relative to the length direction of the middle partition plate 411 gradually decreases.

In this embodiment of this application, the middle partition plate 411 includes a plurality of bolt holes 4116. The plurality of bolt holes 4116 separately extend through the middle partition plate 411 in the first direction. The cover plate 412 includes a plurality of avoidance grooves 4123, and each avoidance groove 4123 is configured to avoid a bolt hole 4116. As shown in FIG. 6, the plurality of avoidance grooves 4123 are provided in a one-to-one correspondence with the plurality of bolt holes 4116. Each avoidance groove 4123 is configured to avoid a corresponding bolt hole 4116.

In this embodiment of this application, each bolt hole 4116 is arranged between two adjacent liquid inlet through holes 4113 or two adjacent liquid outlet through holes 4114 in the length direction of the middle partition plate 411. The plurality of bolt holes 4116 are configured to fasten the liquid cooling heat dissipation apparatus.

In an embodiment, the liquid cooling heat dissipation apparatus 410 is fastened to a housing of the motor control unit 400 through fitting of the plurality of bolt holes 4116 and a plurality of bolts.

In an embodiment, each bolt hole 4116 is arranged between two adjacent liquid inlet through holes 4113 in the length direction of the middle partition plate 411. In an embodiment, each bolt hole 4116 is arranged between two adjacent liquid outlet through holes 4114 in the length direction of the middle partition plate 411.

In this embodiment of this application, the bolt holes 4116 are dispersedly distributed on the middle partition plate 411, so that force uniformity of the liquid cooling heat dissipation apparatus 410 is improved, and the width of the middle partition plate 411 is reduced, thereby reducing the overall width of the liquid cooling heat dissipation apparatus 410, and helping implement miniaturization of the liquid cooling heat dissipation apparatus 410.

FIG. 8 is another diagram of a liquid cooling heat dissipation apparatus 410 according to an embodiment of this application. With reference to FIG. 8, the liquid cooling heat dissipation apparatus 410 includes a cover plate 412, a middle partition plate 411, a bottom plate 413, and a separator wall 416. For the cover plate 412, the middle partition plate 411, and the separator wall 416, refer to the descriptions in the foregoing embodiments. Details are not described herein again. Different from that in the foregoing embodiments, the bottom plate 413 of the liquid cooling heat dissipation apparatus 410 shown in FIG. 8 is of an integrated structure.

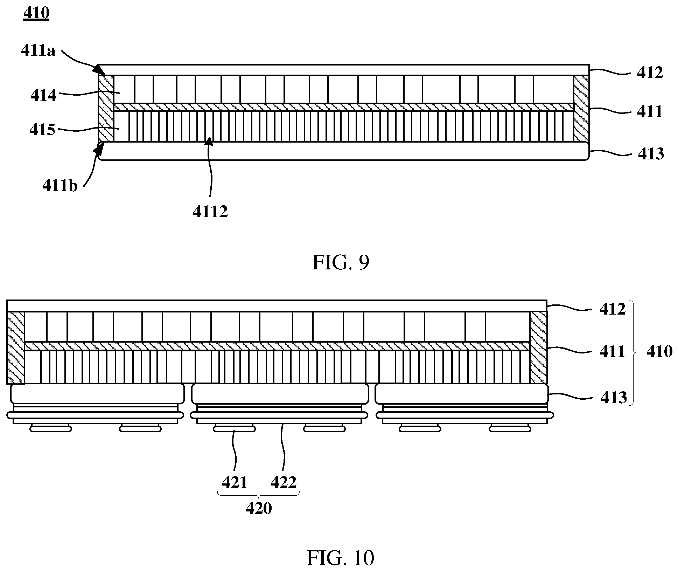

FIG. 9 is another diagram of another liquid cooling heat dissipation apparatus 410 according to an embodiment of this application. With reference to FIG. 9, in this embodiment, the liquid cooling heat dissipation apparatus 410 includes a cover plate 412, a middle partition plate 411, a bottom plate 413, and a separator wall 416. For the cover plate 412, a first side surface 411a of the middle partition plate 411, and the separator wall 416, refer to the descriptions in the foregoing embodiments. Details are not described herein again. Different from that in the foregoing embodiments, a second side surface 411b of the middle partition plate 411 includes one integral second groove 4112.

Correspondingly, there is also one bottom plate 413. The bottom plate 413 and the second groove 4112 enclose a complete second cavity 415. In this case, the liquid cooling heat dissipation apparatus 410 can also implement heat exchange circulation of the heat exchange medium in the liquid cooling heat dissipation apparatus 410 through an upper cavity and a lower cavity. In addition, a first cavity 414 is jointly formed by the middle partition plate 411 and the cover plate 412, and the second cavity 415 is jointly formed by the middle partition plate 411 and the bottom plate 413. This design can effectively reduce a dimension of the liquid cooling heat dissipation apparatus 410 in a height direction, thereby improving compactness of a structure of the liquid cooling heat dissipation apparatus 410.

An embodiment of this application further provides a motor control unit. The motor control unit is configured to receive the battery 100 of the electric vehicle and drive the motor 500. With reference to FIG. 10, the motor control unit includes a power module and the liquid cooling heat dissipation apparatus 410 provided in embodiments of this application. The power module includes one or more power transistor modules 420. Each power transistor module 420 is fastened to a side surface that is of the bottom plate 413 and that is away from the middle partition plate 411, and each power transistor module 420 includes one or more power transistors 421. The liquid cooling heat dissipation apparatus 410 is fastened to a housing of the motor control unit. The power module in the motor control unit includes a direct current-to-alternating current conversion circuit, and the one or more power transistor modules 420 in the power module are configured to form a bridge arm circuit of the direct current-to-alternating current conversion circuit.

After heat generated by the power transistor module 420 during working is transferred to the bottom plate 413, the heat is transferred by the bottom plate 413 to a heat exchange medium flowing in the liquid cooling heat dissipation apparatus 410. The heat exchange medium takes the heat out from the motor control unit in a circulation process, thereby implementing heat dissipation and cooling of the motor control unit.

In an embodiment, the power transistor module 420 includes a bearing substrate 422. As a carrier of the power transistor 421, the bearing substrate 422 provides functions such as electrical connection, protection, support, heat dissipation, and assembly for the power transistor 421. A side that is of the bearing substrate 422 and that is away from the power transistor 421 is in contact with the bottom plate 413, so that heat generated by the power transistor 421 is transferred to the liquid cooling heat dissipation apparatus 410 through the bearing substrate 422. For example, the bearing substrate 422 is a copper-clad ceramic substrate, including but not limited to a direct bonding copper (direct bonding copper, DBC) ceramic substrate or an active metal brazed (active metal brazed, AMB) ceramic substrate. As a result, heat generated by the power transistor 421 during working can be transferred to the liquid cooling heat dissipation apparatus 410 as soon as possible by leveraging excellent heat conduction performance of the DBC or AMB.

In this embodiment of this application, the power transistor 421 includes an insulated-gate bipolar transistor (insulated-gate bipolar transistor), a metal-oxide-semiconductor field-effect transistor (metal-oxide-semiconductor field-effect transistor, MOSFET), a power transistor (power transistor), or the like.

An embodiment of this application further provides an on-board charger (on-board charger, OBC). The on-board charger is configured to receive power supplied by an external power supply and charge the battery 100 of the electric vehicle. With reference to FIG. 10, the on-board charger includes a power module and the liquid cooling heat dissipation apparatus 410 provided in embodiments of this application. The power module includes one or more power transistor modules 420. Each power transistor module 420 is fastened to a side surface that is of the bottom plate 413 and that is away from the middle partition plate 411, and each power transistor module 420 includes one or more power transistors 421. The liquid cooling heat dissipation apparatus 410 is fastened to a housing of the on-board charger. The power module in the on-board charger includes an alternating current-to-direct current conversion circuit, and the one or more power transistor modules 420 in the power module are configured to form a bridge arm circuit of the alternating current-to-direct current conversion circuit.

After heat generated by the power transistor module 420 during working is transferred to the bottom plate 413, the heat is transferred by the bottom plate 413 to a heat exchange medium flowing in the liquid cooling heat dissipation apparatus 410. The heat exchange medium takes the heat out from the on-board charger in a circulation process, thereby implementing heat dissipation and cooling of the power transistor module 420 and the on-board charger.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A liquid cooling heat dissipation apparatus, wherein the liquid cooling heat dissipation apparatus comprises a cover plate, a middle partition plate, a separator wall, and a bottom plate; the cover plate, the middle partition plate, and the bottom plate are sequentially stacked in a first direction; a gap between the cover plate and the middle partition plate forms a first cavity; and a gap between the bottom plate and the middle partition plate forms a second cavity;
the separator wall is arranged between the cover plate and the middle partition plate, and the separator wall is configured to separate the first cavity into a liquid inlet channel and a liquid outlet channel;
the cover plate comprises two openings, the two openings separately extend through the cover plate in the first direction, one of the openings communicates with the liquid inlet channel, and the other opening communicates with the liquid outlet channel; and
the middle partition plate comprises at least one group of through holes, each group of through holes comprises one liquid inlet through hole and one liquid outlet through hole, each liquid inlet through hole and each liquid outlet through hole separately extend through the middle partition plate in the first direction, each liquid inlet through hole is configured to communicate the liquid inlet channel with the second cavity, and each liquid outlet through hole is configured to communicate the liquid outlet channel with the second cavity.

2. The liquid cooling heat dissipation apparatus according to claim 1, wherein a distance between the two openings is less than a length of the first cavity and is greater than a width of the first cavity; in the first direction, a projection of the liquid inlet channel covers a projection of the one opening, and a projection of the liquid outlet channel covers a projection of the other opening; and the projections of the two openings do not overlap with the separator wall in the first direction.

3. The liquid cooling heat dissipation apparatus according to claim 1 or 2, wherein the middle partition plate comprises a first side surface and a second side surface, and the first side surface and the second side surface are opposite to each other in the first direction; and
the first side surface of the middle partition plate comprises a first groove, and the cover plate and the first groove enclose the first cavity.

4. The liquid cooling heat dissipation apparatus according to claim 3, wherein the first groove comprises a groove bottom and a groove wall, and the separator wall is fastened to the groove bottom and the groove wall;
a length direction of the separator wall is tilted relative to a length direction of the first groove, a length of the first groove is less than a length of the separator wall, and the projection of the liquid inlet channel does not overlap with the projection of the liquid outlet channel in the first direction; and
a height of the separator wall is less than or equal to a depth of the first groove in the first direction.

5. The liquid cooling heat dissipation apparatus according to claim 3 or 4, wherein the second side surface of the middle partition plate comprises a second groove, and the bottom plate and the second groove enclose the second cavity.

6. The liquid cooling heat dissipation apparatus according to claim 5, wherein the second groove comprises a plurality of sub-grooves, the plurality of sub-grooves are sequentially arranged adjacent to each other in a length direction of the middle partition plate, and a projection of each sub-groove overlaps with a part of the projection of the liquid inlet channel and a part of the projection of the liquid outlet channel in the first direction.

7. The liquid cooling heat dissipation apparatus according to claim 6, wherein the liquid cooling heat dissipation apparatus comprises at least one group of heat dissipation fins, each group of heat dissipation fins is arranged between the bottom plate and a groove bottom of the second groove, and each group of heat dissipation fins comprises a plurality of heat dissipation fins;
a length of the heat dissipation fin is less than or equal to a depth of the second groove in the first direction; and
the projection of each sub-groove covers projections of a plurality of heat dissipation fins in a group of heat dissipation fins in the first direction.

8. The liquid cooling heat dissipation apparatus according to claim 6, wherein the middle partition plate comprises a plurality of groups of through holes, the projection of each sub-groove covers a liquid inlet through hole and a liquid outlet through hole in a group of through holes in the first direction, and a liquid inlet through hole and a liquid outlet through hole in each group of through holes are provided opposite to each other at a portion that is of the groove bottom of the first groove and that is away from the separator wall.

9. The liquid cooling heat dissipation apparatus according to claim 6, wherein the bottom plate comprises a plurality of bottom sub-plates, and each bottom sub-plate is configured for enclosing with one sub-groove; and
the bottom sub-plate comprises two side surfaces that are opposite to each other in the first direction, one of the side surfaces of the bottom sub-plate comprises a group of heat dissipation fins, and the other side surface of the bottom sub-plate is configured to fasten a power transistor module.

10. The liquid cooling heat dissipation apparatus according to any one of claims 1 to 9, wherein the first side surface of the middle partition plate comprises two groups of guide racks, the two groups of guide racks are respectively arranged on two sides of the separator wall, and in the first direction, a height of the guide rack is less than or equal to a spacing between the middle partition plate and the cover plate.

11. The liquid cooling heat dissipation apparatus according to claim 10, wherein each group of guide racks comprises a plurality of guide racks spaced from each other, a plurality of guide racks in the two groups of guide racks are separately tilted relative to the length direction of the middle partition plate, and tilt directions of the two groups of guide racks are opposite.

12. The liquid cooling heat dissipation apparatus according to claim 11, wherein the projection of the opening in the first direction is in a shape of a circle, and a plurality of guide racks in a same group of guide racks are tilted at a same angle relative to the length direction of the middle partition plate; or
the projection of the opening in the first direction is in a shape of a track oval, and in a same group of guide racks, an angle at which a plurality of guide racks close to the opening are tilted relative to the length direction of the middle partition plate is greater than an angle at which a plurality of guide racks away from the opening are tilted relative to the length direction of the middle partition plate.

13. The liquid cooling heat dissipation apparatus according to claim 1, wherein the middle partition plate comprises a plurality of bolt holes, the plurality of bolt holes separately extend through the middle partition plate in the first direction, the cover plate comprises a plurality of avoidance grooves, and each avoidance groove is configured to avoid a bolt hole; and
each bolt hole is arranged between two adjacent liquid inlet through holes or two adjacent liquid outlet through holes in a length direction of the middle partition plate, and the plurality of bolt holes are configured to fasten the liquid cooling heat dissipation apparatus.

14. A motor control unit, comprising a power module and the liquid cooling heat dissipation apparatus according to any one of claims 1 to 13, wherein
the power module comprises one or more power transistor modules, each power transistor module is fastened to a side surface that is of the bottom plate and that is away from the second cavity, and each power transistor module comprises one or more power transistors.

15. A powertrain, wherein the powertrain comprises a motor and the motor control unit according to claim 14, and the motor control unit is configured to drive the motor.

16. An electric vehicle, comprising a battery, wheels, and the powertrain according to claim 15, wherein the powertrain is configured to receive power supplied by the battery and drive the wheels.
